(19) **Europäisches Patentamt / European Patent Office / Office européen des brevets**

(11) **EP 2 790 051 A1**

(12) **EUROPEAN PATENT APPLICATION**
published in accordance with Art. 153(4) EPC

(43) Date of publication:
**15.10.2014 Bulletin 2014/42**

(51) Int Cl.:
***G02B 27/28*** *(2006.01)*

(21) Application number: **12854759.3**

(86) International application number:
**PCT/JP2012/081812**

(22) Date of filing: **07.12.2012**

(87) International publication number:
**WO 2013/085040 (13.06.2013 Gazette 2013/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.12.2011 JP 2011268974**

(71) Applicant: **Shin-Etsu Chemical Co., Ltd. Tokyo 100-0004 (JP)**

(72) Inventors:
• **YAHAGI Akira**
  **Annaka-shi**
  **Gunma 379-0195 (JP)**

• **WATANABE Toshiaki**
  **Annaka-shi**
  **Gunma 379-0195 (JP)**
• **MAKIKAWA Shinji**
  **Annaka-shi**
  **Gunma 379-0195 (JP)**

(74) Representative: **Vossius & Partner**
  **Siebertstrasse 4**
  **81675 München (DE)**

(54) **OPTICAL ISOLATOR**

(57)     It is an object to provide a small-sized optical isolator that is suitable as an optical isolator used in a semiconductor laser used in applications such as medical treatment or optical measurement

The optical isolator for a wavelength band of 320 to 633 nm of the present invention comprises a Faraday device having a Verdet constant at a wavelength of 405 nm of at least 0.70 min/(Oe·cm), and a first hollow magnet disposed on the outer periphery of the Faraday device and second and third hollow magnet units disposed so as to sandwich the first hollow magnet on the optical axis, the second and third hollow magnet units comprising 2 or more magnets equally divided in a direction of 90 degrees relative to the optical axis, the Faraday device having applied thereto a magnetic flux density B (Oe) within the range of Expression (1) below, and a sample length L (cm) on which the Faraday device is disposed being within the range of Expression (2) below.

$$0.8 \times 10^4 \leq B \leq 1.5 \times 10^4 \qquad (1)$$

$$0.25 \leq L \leq 0.45 \qquad (2)$$

EP 2 790 051 A1

**(Cont. next page)**

*FIG.1*

**Description**

Technical Field

The present invention relates to an optical isolator used in a wavelength band of 320 to 633 nm.

Background Art

Conventionally, industrial lasers that are used in applications such as medical treatment and optical measurement employ semiconductor lasers in UV and visible regions, or the second harmonic (wavelength 532 nm) or third harmonic (wavelength 355 nm) of a lamp-pumped YAG laser.

In recent years, the applications of such semiconductor laser wavelengths have widened, and the output thereof has been increasing.

However, although semiconductor lasers are generally characterized by a narrow beam emission spectrum and excellent conversion efficiency, they are very sensitive to backward beam due to reflected beam, and their characteristics become unstable if reflected beam returns from an end face bonded to an optical fiber or from a material to be measured. Therefore, in order to prevent reflected beam from returning to a beam-emitting device, which is a beam emitting source, and guarantee stable operation of a semiconductor laser, it is essential to block beam that has been reflected from an optical fiber and is returning to the beam emitting source by disposing, between the beam emitting source and a workpiece, an optical isolator that has the function of transmitting beam in the forward direction and blocking beam in the reverse direction.

Here, the optical isolator is formed from three essential components, that is, a Faraday device, a pair of polarizers disposed on the side of the Faraday device on which beam is incident and the side from which beam emerges, and a magnet that applies a magnetic field in the direction of beam transmission of the Faraday device (optical axis direction). When beam is incident on the Faraday device in this configuration, a phenomenon occurs in which the plane of polarization rotates in the Faraday device. This phenomenon is called the Faraday effect; the angle through which the plane of polarization rotates is called the Faraday rotation angle, and its magnitude $\theta$ is represented by the equation below.

$$\theta = V \times H \times L$$

In the equation above, V is the Verdet constant, which is a constant determined by the material of the Faraday device and the measurement wavelength, H is the magnetic flux density, and L is the length of the Faraday device. As can be understood from this equation, in order to obtain a desired Faraday rotation angle in a device having a certain fixed magnitude for the Verdet constant, the larger the magnetic field applied to the Faraday device the shorter the length of the device can be, and the longer the length of the device the smaller the magnetic flux density can be.

As described in Patent Document 1, as a material having a large Verdet constant in the above wavelength band, there is an Fe-containing YIG (yttrium iron garnet) single crystal.

Other than the above, there is terbium gallium garnet (chemical formula: $Tb_3Ga_5O_{12}$), etc.

Furthermore, lead-containing glass is also used.

In order to have a function as an optical isolator, a Faraday rotation angle of on the order of 45° is necessary. Specifically, the plane of polarization of beam that enters the optical isolator is rotated through 45° by the Faraday device, and the beam is transmitted through the incident/output polarizers whose angles have been adjusted individually. On the other hand, the plane of polarization of backward beam is rotated through 45° in the opposite direction by utilizing the nonreciprocity of the Faraday device to thus give an orthogonal plane of polarization that is at 90° to the input polarizer, and the beam cannot be transmitted. The optical isolator utilizes this phenomenon, allows beam to be transmitted only in a single direction, and blocks beam that has returned after being reflected.

Prior Art Documents

Patent Documents

Patent Document 1: JP-A-2011-150208 (JP-A denotes a Japanese unexamined patent application publication)

Summary of Invention

The YIG single crystal described in Patent Document 1 has a large beam absorption at wavelengths of 320 to 800 nm. Therefore, it cannot be used for wavelengths of 320 to 800 nm because of the strong influence of the absorption.

A conventionally used optical isolator uses a Faraday device such as for example a terbium gallium garnet (TGG) crystal. Although the Verdet constant of TGG is large, being on the order of 0.46 min/(Oe·cm) at a wavelength of 633 nm, since there is a large beam absorption at wavelengths of 500 to 600 nm, and the beam absorption has a strong influence at wavelengths of 320 to 380 nm and 450 to 550 nm, its use at wavelengths of 633 nm and below is limited. 1 min means 1/60 of a degree.

Furthermore, lead-containing glass has a small Verdet constant at wavelengths of 320 to 800 nm, and when it is used as a Faraday device, the optical path becomes longer.

It is an object of the present invention to provide a small-sized optical isolator that is transparent at wavelengths of 320 to 633 nm. In particular, it is to provide a small-sized optical isolator that is suitable as an optical isolator used in a semiconductor laser used in applications such as medical treatment or optical measurement.

It is another object of the present invention to provide an optical isolator that combines the use of a Faraday device having a high Faraday effect with a magnet having a small external form. Other objects of the present invention will become apparent from the explanation below.

The objects have been accomplished by means <1> below. It is described below together with <2> to <11>, which are preferred embodiments.

<1> An optical isolator for a wavelength band of 320 to 633 nm comprising a Faraday device having a Verdet constant at a wavelength of 405 nm of at least 0.70 min/(Oe·cm), and a first hollow magnet disposed on the outer periphery of the Faraday device and second and third hollow magnet units disposed so as to sandwich the first hollow magnet on the optical axis, the second and third hollow magnet units each comprising 2 or more magnets equally divided in a direction of 90 degrees relative to the optical axis, the Faraday device having applied thereto a magnetic flux density B (Oe) in the range of Expression (1) below, and the Faraday device being disposed on a sample length L (cm) in the range of Expression (2) below,

$$0.8 \times 10^4 \leq B \leq 1.5 \times 10^4 \qquad (1)$$

$$0.25 \leq L \leq 0.45 \qquad (2)$$

<2> the optical isolator according to <1>, wherein the Faraday device comprises an oxide represented by Formula (I) below in an amount of at least 95 wt%,

$$Yb_2O_3 \qquad (I)$$

<3> the optical isolator according to <2>, wherein the oxide is a single crystal,

<4> the optical isolator according to <2>, wherein the oxide is a ceramic,

<5> the optical isolator according to any one of <1> to <4>, wherein the Faraday device has an insertion loss of no greater than 1 dB and an extinction ratio of at least 30 dB for a sample length L (cm),

<6> the optical isolator according to any one of <1> to <5>, wherein the first hollow magnet and the second and third hollow magnet units comprise a neodymium-iron-boron (NdFeB) system magnet,

<7> the optical isolator according to any one of <1> to <6>, wherein the first hollow magnet has a magnetic field polarity in the direction of the optical axis and the second and third hollow magnet units have mutually opposite magnetic field polarities in directions normal to the optical axis,

<8> the optical isolator according to any one of <1> to <7>, wherein the second and third hollow magnet units are of a collection of four magnets formed by dividing a cylindrical magnet into four at 90°,

<9> the optical isolator according to any one of <1> to <8>, wherein it further comprises at least two tabular birefringent crystals and at least one 45 degree optical rotator,

<10> the optical isolator according to <9>, wherein the tabular birefringent crystal has an optic axis that is at substantially 45 degrees relative to the optical axis and has a thickness of at least 1.0 cm, and

<11> the optical isolator according to any one of <1> to <10>, wherein the first hollow magnet, the second hollow magnet unit, and the third hollow magnet unit are mounted in the interior of a carbon steel housing.

In accordance with the invention described in <1>, a small-sized optical isolator can be achieved by the use of a Faraday device having a high Verdet constant, a magnetic material having a large magnetic flux density, and a magnetic circuit.

Furthermore, in accordance with the invention described in <2>, since the content of $Yb_2O_3$ oxide, which affects polarization rotation performance, is at least 95%, the length of a Faraday device sample having a content of 50% can be shortened to about 1/2, and optical damage to the Faraday device that might be caused by a high output laser can be suppressed.

In accordance with the invention described in <7> above, the size can be further reduced by increasing the magnetic flux density applied to the Faraday device.

In accordance with the invention described in <8> above, in addition to the small size, polarization independence can be achieved.

Brief Description of Drawings

FIG. 1: A cross-sectional schematic drawing showing an example of the constitution of the optical isolator of the present invention.

FIG. 2: A cross-sectional schematic drawing of a second hollow magnet unit 8 and a third hollow magnet unit 9.

FIG. 3: A schematic view showing, along the optical axis, behavior of the plane of polarization of incident beam and backward beam within an optical isolator.

FIG. 4: A diagram showing the magnitude of magnetic flux density T ($10^4$ Oe) at which the Faraday rotation angle becomes 45 degrees with respect to sample length L (0.25 to 0.45 cm) of a Faraday device used in Example 1 and Comparative Example 1.

FIG. 5: A diagram showing shape analysis results of an NdFeB system magnet based on a finite element method.

Description of Embodiments

The optical isolator of the present invention comprises a Faraday device having a Verdet constant at a wavelength of 405 nm of at least 0.70 min/(Oe·cm), and a first hollow magnet disposed on the outer periphery of the Faraday device and second and third hollow magnet units disposed so as to sandwich the first hollow magnet on the optical axis, the second and third hollow magnet units comprising 2 or more magnets equally divided in a direction at 90 degrees to the optical axis, the Faraday device having applied thereto a magnetic flux density B (Oe) in the range of Expression (1) below, and a sample length L (cm) on which the Faraday device is disposed being within the range of Expression (2) below.

$$0.8 \times 10^4 \leq B \leq 1.5 \times 10^4 \qquad (1)$$

$$0.25 \leq L \leq 0.45 \qquad (2)$$

Since the Faraday device used in the present invention is a transparent Faraday device that has very little beam absorption at wavelengths of 320 to 633 nm, it can be applied to a wavelength band in which a conventional device such as a TGG crystal cannot function. The use, in this Faraday device, of a magnetic material having a large magnetic flux density and a magnetic circuit enables the size of the optical isolator to be reduced. Because of this, the degree of freedom in terms of spatial dimensions within a device into which the optical isolator is incorporated can be increased.

The present invention is explained in detail below.

The optical isolator of the present invention is preferably used for laser beam in a wavelength band of 320 to 633 nm. Such lasers include semiconductor lasers and the second harmonic (wavelength 532 nm) or third harmonic (wavelength 355 nm) of a lamp-pumped YAG laser.

A person skilled in the art can modify the optical isolator of the present invention so that it can be used for laser beam having a wavelength band other than the above-mentioned band.

An example of the basic constitution of the optical isolator of the present invention is explained below by reference to the drawings.

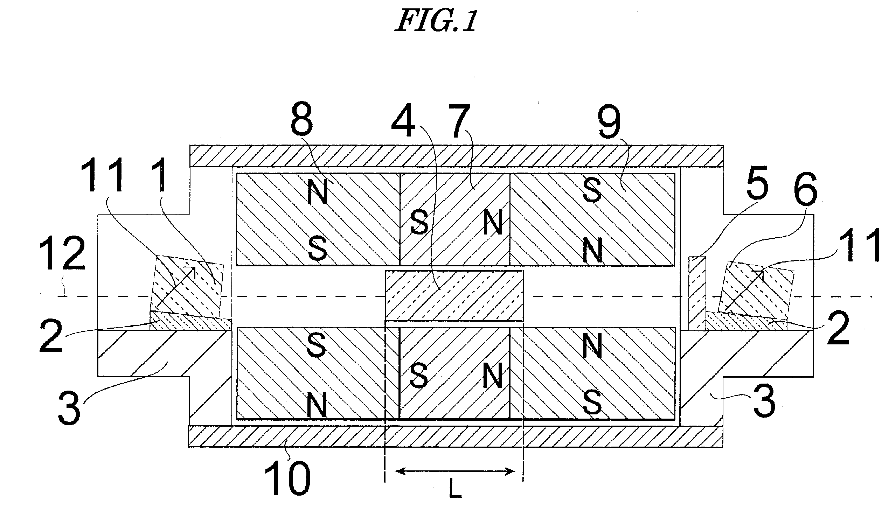

FIG. 1 is a cross-sectional schematic drawing showing an example of the constitution of the optical isolator of the present invention.

In FIG. 1, an input polarizer 1, a Faraday device 4, and an output polarizer 6 are disposed on an optical axis 12 in sequence from the incident side on the left-hand side toward the output side on the right-hand side.

In FIG. 1, the input polarizer 1 is fixed on the optical axis 12 by means of a glass wedge 2 and the output polarizer 6 is also fixed by means of a glass wedge 2. On the incident side the input polarizer 1 is fixed to a polarizer holder 3 and on the output side a 45 degree optical rotator 5 and the output polarizer 6 are fixed to a polarizer holder 3. Furthermore, an optic axis 11 is shown for the input polarizer 1 and the output polarizer 6.

The shape of the Faraday device 4 is not particularly limited; it may be a triangular column shape or a square column shape, but is preferably a cylindrical shape. The explanation below is given with a cylindrical Faraday device as an example.

Disposed on the outer periphery of the Faraday device 4 are a first hollow magnet 7, and a second hollow magnet unit 8 and a third hollow magnet unit 9 sandwiching the first hollow magnet on the optical axis. When the Faraday device 4 is cylindrical, it is preferable for all of the first hollow magnet 7, the second hollow magnet unit 8, and the third hollow magnet unit 9 to be hollow cylinders, and it is preferable for the central axis of the Faraday device 4 and the central axes of the hollow portion of the first hollow magnet 7 and the hollow portions of the two hollow magnet units 8 and 9 to be coaxial. Furthermore, the outer diameter of the Faraday device 4 is preferably substantially the same as the inner diameter of the hollow portion of the first hollow magnet 7 and the inner diameters of the hollow portions of the two hollow magnet units 8 and 9, and it is preferably for the centers to be adjusted after the optical isolator is assembled. This arrangement allows the Faraday device 4 to be disposed in the center of the first hollow magnet 7.

The first hollow magnet 7, the second hollow magnet unit 8, and the third hollow magnet unit 9 are disposed so that their hollow portions are coaxial with the optical axis. Both of these two hollow magnet units 8 and 9 are a collection of a plurality of magnets equally divided into two or more in directions at 90 degrees (90°) to the optical axis, that is, in a plane perpendicular to the optical axis.

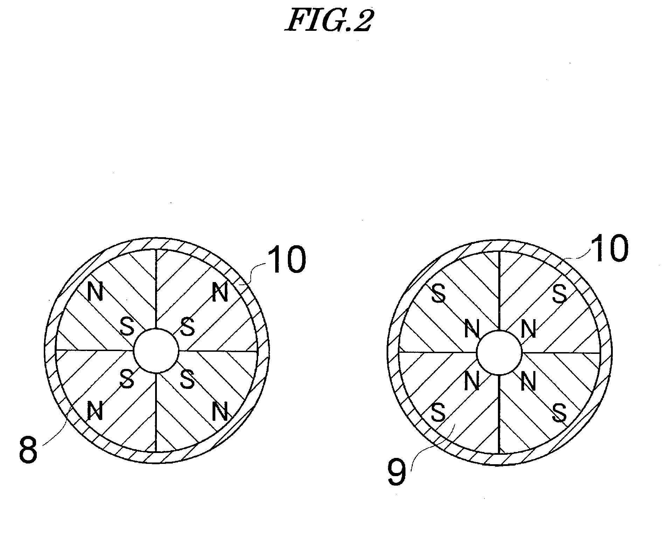

FIG. 2 is a cross-sectional schematic drawing showing one embodiment of the two hollow magnet units 8 and 9. Both of the two hollow magnet units are a collection of 4 magnets formed by dividing a cylindrical magnet into four 90° portions. A magnet unit (collection) divided into 4 portions is preferable since its suitability for machining is excellent. Other than this configuration of the magnet unit divided into four, a collection of two magnets divided into two 180° portions or a collection of three magnets divided into three 120° portions may also be used.

As shown in FIG. 2, the second hollow magnet unit 8 and the third hollow magnet unit 9 are each housed in the interior of a housing 10.

In the embodiment shown in FIG. 2, the magnets formed by dividing a cylindrical magnet into four have the magnetic field polarity thereof in the circumferential direction. In this case, since the magnets have mutually opposite magnetic forces, by making the outer diameter of the outer periphery of the combined magnet unit and the inner diameter of the housing 10 substantially equal to each other so that the magnet unit can be inserted, they can be fixed in the interior of the housing 10 simply by virtue of the opposite magnetic forces thereof. Since, by the use of this fixing method, the first hollow magnet 7 can be fixed without any gap while having opposite sides thereof retained by means of the second hollow magnet unit 8 and the third hollow magnet unit 9, fixing of all of the constituent magnets does not require any adhesive, etc., thus enabling mounting to be achieved with high reliability.

Here, the 'magnetic field polarity' means the direction of magnetization. That is, it denotes the direction of magnetic lines of force.

The optical isolator of the present invention comprises a Faraday device having a Verdet constant of at least 0.70 min/(Oe·cm) at a wavelength of 405 nm. This Faraday device is now explained.

The Faraday device that can be used in the present invention has a Verdet constant of at least 0.70 min/(Oe·cm) at a wavelength of 405 nm. The Verdet constant is not particularly limited as long as it is at least 0.70 min/(Oe·cm), but the Verdet constant for a $Yb_2O_3$ oxide content of 100% is the upper limit. When the Verdet constant is less than 0.70 min/(Oe·cm), the length of the Faraday device required to give a Faraday rotation angle of 45° becomes large, and it becomes difficult to reduce the size of the optical isolator.

In the present invention, the Verdet constant may be measured in accordance with a standard method, which is not particularly limited.

Specifically, a predetermined thickness of an oxide is cut out and subjected to mirror polishing, the Faraday device is set in a permanent magnet having a known magnetic flux density, and the Verdet constant at a wavelength of 405 nm is measured. The measurement conditions are 25°C ± 10°C, and measurement is carried out in air.

A sample length L (cm) on which the Faraday device is disposed in the optical isolator of the present invention is within the range of Expression (2).

$$0.25 \leq L \leq 0.45 \qquad (2)$$

When the sample length exceeds 0.45 cm, it becomes difficult to reduce the size of the optical isolator, and when it is less than 0.25 cm the magnitude of the magnetic flux density needed to obtain a required Faraday rotation angle increases, thus making it difficult to reduce the size of the Faraday isolator.

The sample length on which the Faraday device is disposed referred to here means the length on the optical axis of the Faraday device, and is denoted by L in FIG. 1.

The Faraday device used in the present invention preferably comprises an oxide represented by Formula (I) below in an amount of at least 95 wt%.

$$Yb_2O_3 \qquad (I)$$

The content of the oxide is more preferably at least 99.9 wt%, and yet more preferably 100 wt%.

In the same way as for terbium (Tb), ytterbium (Yb) has an orbital angular momentum L of 3, is therefore a paramagnetic element, and is an element that has no absorption at wavelengths of 320 to 633 nm. Because of this, it is the most suitable element for use in an optical isolator for this wavelength region.

On the other hand, terbium has a larger Verdet constant than that of ytterbium but has absorption at wavelengths of 320 to 380 nm and 450 to 550 nm. Therefore, producing a compound comprising as much ytterbium as possible enables the Verdet constant of the compound to be increased and the Faraday rotation angle to be increased.

Furthermore, in order to produce a compound having no absorption at wavelengths of 320 to 633 nm, it is necessary for other constituent elements to be transparent in that wavelength region, and the most suitable compound therefor is an oxide of an element having no absorption at wavelengths of 320 to 633 nm.

The main factors determining the size of an optical isolator are the magnitudes of the Verdet constant and the magnetic field. In order to produce a small-sized optical isolator, it is necessary to develop a material that enables a Faraday device, which is a constituent component thereof, to be shortened as much as possible.

It has been found that it is desirable that the Verdet constant at the wavelength employed is at least 0.20 min/(Oe·cm); if it is less than this value the length of the Faraday device becomes 10 mm or greater for the magnetic field employed, and the optical isolator dimensions and transmission loss increase.

As a result of further investigation and experiment, it has been found that for a material comprising an ytterbium oxide in an amount of 95 wt% on a ratio by weight basis, the Verdet constant is at least 0.20 min/(Oe·cm), the length of the Faraday device is no greater than 10 mm, the size of the optical isolator can be made small, and there is hardly any absorption of beam at wavelengths of 320 to 633 nm.

An oxide represented by Formula (I) above may be a single crystal or may be a ceramic. A process for producing such a single crystal or ceramic may be referred to in JP-A-2011-150208, etc.

When a single crystal is used as a Faraday device of an optical isolator, it is preferable for the surface to be mirror-finished using an abrasive, etc. after cutting. The abrasive is not particularly limited, and examples include colloidal silica.

The Faraday device that can be used in the present invention preferably has an insertion loss of no greater than 1 dB and an extinction ratio of at least 30 dB over the sample length L (cm) in the optical isolator of the present invention, and while taking into consideration errors caused by mounting and assembling it to the optical isolator it more preferably has an insertion loss of no greater than 0.5 dB and an extinction ratio of at least 35 dB. It is preferable for them to be in the above-mentioned ranges since an optical isolator having low loss and high isolation in terms of optical properties can be prepared.

Optical properties such as insertion loss and extinction ratio are measured in accordance with standard methods at a wavelength of 405 nm. The measurement conditions are 25°C ± 10°C and measurement is carried out in air.

The Faraday device that can be used in the present invention preferably has a transmittance (beam transmittance) of at least 80% at a wavelength of 405 nm and a sample length of L cm ($0.25 \leq L \leq 0.45$), more preferably at least 82%, and yet more preferably at least 85%. The transmittance is preferably high; the upper limit thereof is not particularly limited, but is no greater than 100%.

Transmittance is measured as the intensity of beam when beam having a wavelength of 405 nm is transmitted through a Faraday device having a thickness of L cm. That is, the transmittance is represented by the equation below.

$$\text{Transmittance} = I/I_o \times 100$$

(In the equation, I denotes the intensity of transmitted beam (intensity of beam that has been transmitted through a sample having a thickness of L cm), and Io denotes the intensity of incident beam.)

When an oxide that is obtained has nonuniform transmittance, and the transmittance varies depending on the point of measurement, the transmittance of said oxide is defined as the average transmittance of any 10 points.

The hollow magnet unit group comprising the first hollow magnet, the second hollow magnet unit, and the third hollow magnet unit in the optical isolator of the present invention is now explained further.

The first hollow magnet and the second and third hollow magnet units are all preferably permanent magnets having as small a size as possible, and in order to obtain a large magnetic field intensity it is preferable to use a neodymium-iron-boron (NdFeB) system magnet.

In the optical isolator of the present invention, it is preferable that, as shown in FIG. 1, the magnetic field polarity of the first hollow magnet is in the direction of the optical axis, and the magnetic field polarity of the second hollow magnet unit and the magnetic field polarity of the third hollow magnet unit are mutually opposite in a direction normal to the optical axis. In accordance with this constitution, it is possible to maximize the magnetic flux density applied to the Faraday device.

In the basic design of the optical isolator of the present invention, it is important to shorten the length of the Faraday device in order to achieve a reduction in size, and the reduction in size is achieved by combining a Faraday device having a large Faraday effect with a magnet material (magnet) having a high magnetic flux density and a magnetic circuit. Furthermore, since optical damage to the Faraday device due to high power beam, which is a problem in semiconductor lasers, is determined by the transmittance and length of the Faraday device, the higher the transmittance and the shorter the length of the Faraday device the better.

The optical isolator of the present invention preferably further comprises two or more sheets of tabular birefringent crystal and one or more 45 degree optical rotators on the optical axis. In accordance with this constitution, a polarization-independent optical isolator can be obtained.

In this case, it is preferable that the optic axis of the tabular birefringent crystal is in a direction at substantially 45° relative to the optical axis and the thickness is at least 1.0 cm. For example, when a rutile single crystal ($TiO_2$) is used, it can be used for a beam diameter of ø1.0 mm, which is 1/10 of the thickness, and when an $\alpha$-BBO crystal ($BaB_2O_4$) is used, it can be used for a beam diameter of ø0.35 mm, which is 1/30 of the thickness.

Accompanying increases in the output of semiconductor lasers, the requirements for optical isolators mounted therein include the durability of each component toward high power beam and being polarization-independent such that they are free from the influence of the state of polarization of the transmitted beam. In order to meet such requirements, a polarizer used is most suitably a birefringent crystal, which splits an optical beam by utilizing difference in refractive index. As representative birefringent crystals, there are yttrium vanadate ($YVO_4$) and a rutile single crystal ($TiO_2$), which are transparent at wavelengths of 400 to 633 nm, a calcite ($CaCO_3$) single crystal, which is transparent at wavelengths of 350 to 633 nm, and an $\alpha$-BBO crystal ($BaB_2O_4$), which is transparent at wavelengths of 190 to 633 nm, and a birefringent crystal that is transparent at the emission wavelength of a semiconductor laser may be used. Furthermore, in order to achieve the above-mentioned polarization independence, it is preferable to carry out flat machining such that the optic axis of the birefringent crystal is preferably approximately 45 degrees relative to the optical axis. Furthermore, since there is a proportional relationship between the thickness thereof and the separation distance of the extraordinary ray, each may be machined with high precision to a thickness that satisfies a desired amount of beam shift. Two of these tabular birefringent polarizers are disposed as incident/emerging beam polarizers; disposed between these two are a Faraday device that has a Faraday device angle of 45 degrees at any wavelength from 320 to 633 nm and a 45 degree optical rotator that rotates the plane of polarization through 45 degrees at the same wavelength, and disposed therearound is a magnet that gives a magnetic field in the direction of the optical axis of the Faraday device, thus constituting a polarization-independent optical isolator.

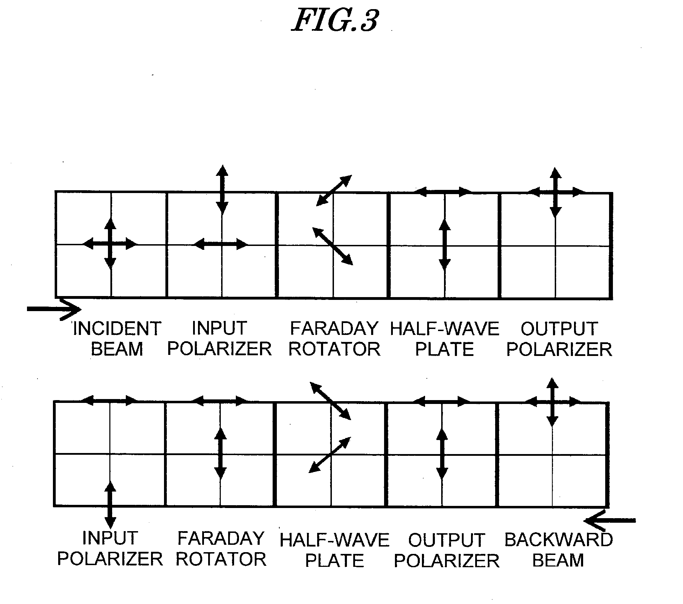

FIG. 3 shows, along the optical axis, the behavior of the plane of polarization of incident beam and backward beam within an optical isolator.

At the top of FIG. 3, the behavior of the plane of polarization of incident beam is shown. First, incident beam is split in accordance with Snell's law into two, that is, the extraordinary ray that shifts in the polarization direction of the optic axis of the input polarizer and the ordinary ray that goes straight on in the polarization direction normal to the optic axis. With regard to the incident beam, the ordinary ray and the extraordinary ray with planes of polarization of 0 degrees and 90 degrees respectively, which are split in the input polarizer 1, are each rotated clockwise through 45 degrees by the Faraday device 4. The optic axis of a half-wave plate is disposed at 22.5 degrees within the plane such that the plane of polarization is further rotated clockwise through 45 degrees. When the ordinary ray and the extraordinary ray pass through the half-wave plate with this constitution, since the planes of polarization are both rotated clockwise through 45 degrees, the ordinary ray and the extraordinary ray each have their planes of polarization rotated through 90 degrees. As a result, since the output polarizer 6 has an optic axis in the same direction as that of the input polarizer 1, the ordinary ray undergoes beam shifting as an extraordinary ray, and the extraordinary ray goes straight on as an ordinary ray, the two beams coinciding with each other to thus achieve polarization independence.

At the bottom of FIG. 3, the behavior of the plane of polarization of backward beam is shown. With regard to backward beam, the plane of polarization is rotated through 45° in the opposite direction by utilizing the nonreciprocity of the Faraday device and becomes a perpendicular polarization plane, which is 90° to the input polarizer, thus making transmission impossible.

In the optical isolator of the present invention, it is preferable for the first hollow magnet, the second hollow magnet unit, and the third hollow magnet unit to be mounted in a carbon steel housing. Due to them being housed in the carbon steel housing, a yoke is formed around the magnets, thus increasing the attractive power or attracting power of the magnet.

As described in the explanation of FIG. 2, when the outer diameter of four equally divided magnet units is made to coincide substantially with the inner diameter of the housing 10 so that the magnet can be inserted, two magnet units can be fixed in the interior of the housing only by means of opposing magnetic forces between the respective magnets.

Examples

(Example 1)

An optical isolator for the 405 nm band having the constitution shown in FIG. 1 was prepared.

As an input polarizer 1 and an output polarizer 6, $\alpha$-BBO crystals ($BaB_2O_4$) having high transparency at 405 nm were used, the beam transmitting surfaces thereof were machined so as to give parallel plates having a thickness of 1.0 cm, and an optic axis 11 was inclined by 47.8 degrees relative to an optical axis 12. In FIG. 1, the direction of inclination is drawn so as to be in the plane of paper. Furthermore, these parallel plate polarizers had an anti-reflection coating having a center wavelength of 405 nm on the beam transmitting surface, and in order to avoid beam reflected via the beam transmitting surface from returning to the incident beam path, the polarizer bottom face was adhered to a glass wedge 2 having an angle of inclination of only 5 degrees and mounted on a polarizer holder 3.

Furthermore, a Faraday device 4 was positioned at the center of the hollow portion of a first hollow magnet 7, and fixed at a position where the magnetic filed distribution formed by the all magnets including a second hollow magnet unit 8 and a third hollow magnet unit 9 was a maximum. For the second and third magnet units, as shown in FIG. 2, four equally divided magnets were combined and used. A 45 degree optical rotator 5, which was disposed after the Faraday device 4 in the incident beam path, employed a half-wave plate comprising an artificial quartz, and its beam transmitting surface was subjected to an anti-reflection coating having a center wavelength of 405 nm.

As the Faraday device, an yttrium oxide having a Verdet constant of at least 0.70 min/(Oe·cm) at a wavelength of 405 nm was used with a sample length of 0.25 to 0.45 cm. A hollow magnet comprising a neodymium-iron-boron (NdFeB) system magnet was disposed on the outer periphery of the Faraday device. A magnetic circuit was formed by disposing hollow magnet units that were equally divided into four in directions of 90 degrees relative to the optical axis and having opposite magnetic field polarities on opposite sides of the hollow magnet, the magnetic field polarities of the respective divided magnets being in a direction normal to the optical axis. A carbon steel housing was disposed on the outside of the magnet and the magnet units.

The amount of beam shift of a parallel plate polarizer depends on the thickness thereof. In the present Examples, in which the thickness of the parallel plate polarizer is 1.0 cm, the amount of beam shift is about 0.35 mm. With regard to the backward beam, since it emerges while being split from the position of incidence by 0.35 mm in the vertical direction, when taking into account the optical isolator function, application to a maximum beam diameter ($1/e^2$) of ø0.35 mm is possible. Furthermore, when a larger beam diameter is handled for the purpose of decreasing the power density of high power beam, etc., the thickness of the parallel plate polarizer may be set at any value that is 1.0 cm or greater while ensuring an effective region for the Faraday device.

Details of the Faraday device 4 used in Example 1 are now explained. As a material, a $Yb_2O_3$ ceramic comprising an ytterbium oxide at 100 wt% was used. The $Yb_2O_3$ ceramic was produced in accordance with a method described in JP-A-2011-150208. Specifically, a high purity $Yb_2O_3$ powder was ground and then wet-mixed by adding ethanol and ethylene glycol to thus give a slurry, and this slurry was molded using a mold. The molding obtained was calcined at 1,600°C for 2 hours under an atmosphere of argon, thus giving a ceramic.

When this ceramic was measured at a wavelength of 405 nm, it was found that it had optical characteristics of an insertion loss of 0.5 dB, an extinction ratio of 40 dB, and a Verdet constant of 0.74 min/(Oe·cm). The sample measured here was a cylindrical shape having an outer diameter of ø0.3 cm and a length of 0.4 cm.

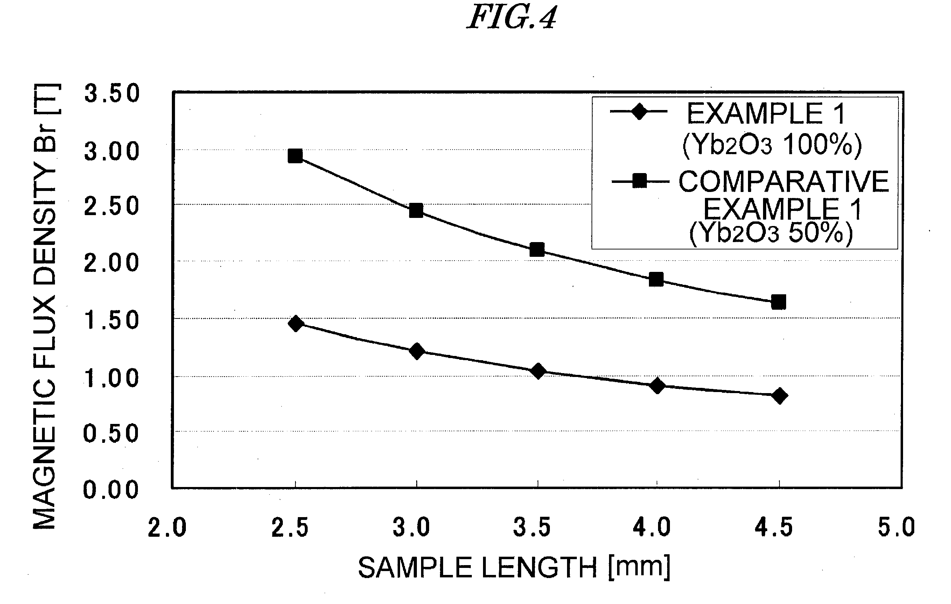

FIG. 4 shows the magnetic flux density T ($10^4$ Oe) that gave a Faraday rotation angle of 45 degrees as a function of sample length L (cm) when the sample length of the ceramic used in Example 1 was changed from 0.25 to 0.45 cm at 0.05 cm intervals.

In the case in which the above-mentioned sample length was 0.4 cm, when the magnetic flux density that gave a Faraday rotation angle of 45 degrees was calculated from the Verdet constant value (0.74 min/(Oe·cm)) of Example 1, it was found that the required magnetic flux density was about 9,100 Oe (= 0.91 [T]).

(Comparative Example 1)

As shown in FIG. 4, an optical isolator in which a $Yb_2O_3$ ceramic containing an ytterbium oxide at 50 wt% (Verdet constant 0.37 min/(Oe·cm)) was the Faraday device was prepared as Comparative Example 1.

When the magnetic flux density applied to this $Yb_2O_3$ ceramic was calculated, it was found that the magnetic flux density required at a sample length of 0.4 cm was about 18,200 [Oe] (= 1.82 [T]), and similarly at a sample length of 0.45 cm, which corresponded to the lower limit for the magnetic flux density, it was about 16,000 [Oe] (= 1.6 [T]).

Therefore, in the optical isolators of the present invention, the relationship between magnetic flux density and sample length was the relationship shown by Example 1, and all were within a range that satisfied Expression (1) in <1> above.

Compared with a magnet used for a Faraday device with $Yb_2O_3$ at 50 wt%, in the optical isolator of the present invention, since the sample length of the Faraday device and the magnetic flux density applied can be made small, the outer diameter of the magnet can be made small, and as a result a small-sized optical isolator can be realized. In addition to reduction in the size of the optical isolator product shape, magnetic field leakage from the optical isolator to the outside can also be reduced.

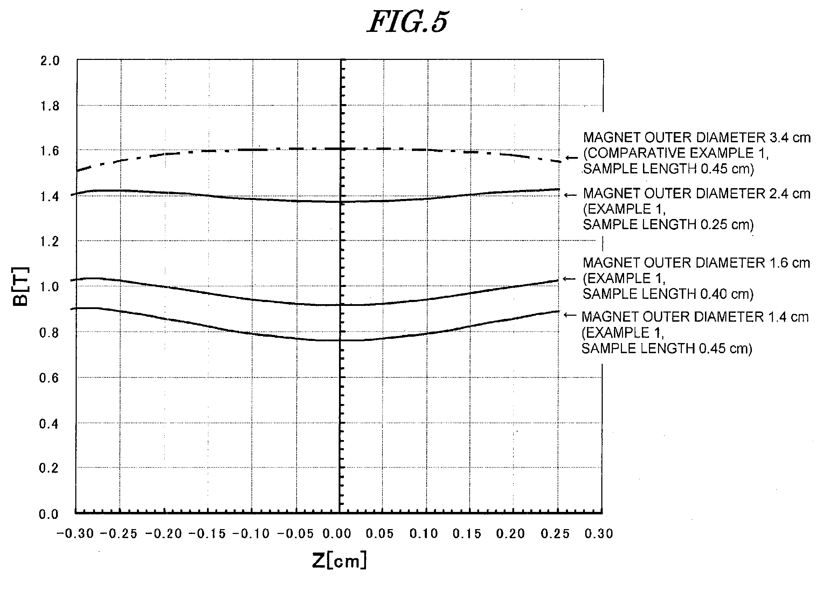

In order to realize the above, the magnetic flux density distribution to be obtained was determined by magnetic field analysis using the outer diameter of each magnet as a parameter. As an analytical method, a finite element method (JMAG-Designer) was selected, the magnet material was a neodymium-iron-boron (NdFeB) magnet manufactured by Shin-Etsu Chemical Co., Ltd., and the material of the housing 10 was carbon steel. The simulation results are shown in FIG. 5.

The inner diameter ø (diameter) and the outer diameter ø (diameter) of the magnet in FIG. 5 were as follows.

Example 1 (sample length 0.45 cm): magnet inner diameter ø0.4 cm, outer diameter ø1.4 cm

Example 1 (sample length 0.40 cm): magnet inner diameter ø0.4 cm, outer diameter ø1.6 cm

Example 1 (sample length 0.25 cm): magnet inner diameter ø0.4 cm, outer diameter ø2.4 cm

Comparative Example 1 (sample length 0.45 cm): magnet inner diameter ø0.4 cm, outer diameter ø3.4 cm

In FIG. 5, Z (cm) denotes the distance from the central axis where the Faraday device is disposed, and 0 cm denotes the middle on the central axis (the middle of the Faraday device that is disposed). That is, when the sample length of the Faraday device is 0.45 cm, the end points of the Faraday device correspond to Z = ±0.225 cm, and similarly when the sample length of the Faraday device is 0.40 cm, the end points of the Faraday device correspond to Z = ±0.20 cm.

From the results of the simulation in FIG. 5, it was found that a stable magnetic flux density relative to the optical axis direction (Z) could be obtained.

The upper limit for the magnetic flux density that satisfies Expression (1) and Expression (2) denotes the magnetic flux density distribution at a sample length of 0.25 cm in Example 1 and the lower limit for the magnetic flux density denotes the magnetic flux density distribution at a sample length of 0.45 cm in Example 1, the magnet shapes being an inner diameter of ø0.4 cm and an outer diameter of ø1.4 (lower limit) to ø2.4 cm (upper limit).

In order to satisfy a magnetic flux density of 9,100 Oe (= 0.91 [T]) applied to the Faraday device 4 (sample length 0.4 cm, outer diameter ø0.3 cm) used in Example 1, Example 1 (sample length 0.40 cm) in FIG. 5 was the most suitable. From this result, the magnet shape used when the constitution of Example 1 was employed was an inner diameter of ø0.4 cm, an outer diameter of ø1.6 cm, and a length of 3.2 cm when it was actually produced by combining the first, second, and third hollow magnets. When the Faraday rotation angle of this assembled product was measured at a wavelength of 405 nm, the Faraday rotation angle was 45.0 degrees, which coincided with the simulation result. When an optical isolator was assembled by combining this with as a polarizer an $\alpha$-BBO crystal ($BaB_2O_4$), which is transparent at 405 nm, an optical isolator having optical characteristics with an insertion loss of 0.7 [dB] and an isolation of 35 [dB] could be produced.

The magnet shape employing the 50% $Yb_2O_3$ ceramic having a sample length of 0.45 cm, which was the lower limit value for the conventional constitution shown in Comparative Example 1, was an inner diameter of ø0.4 cm, an outer diameter of ø3.4 cm, and a length of 3.8 cm, and comparing the two it was found that the present invention realized a size reduction of 80% as a ratio by volume compared with the conventional product.

Furthermore, it is generally known that the Verdet constant is dependent on wavelength, and the constant becomes smaller when the wavelength becomes longer. Therefore, the Verdet constant was also evaluated at 633 nm, which is the upper limit of 320 to 633 nm. From the results, it was found that the Verdet constant of each of the $Yb_2O_3$ ceramics used in Example 1 was 0.22 min/(Oe·cm) compared with 0.11 min/(Oe·cm) in Comparative Example 1, thus satisfying a level of at least 0.20 min/(Oe·cm), which is a guideline for shortening a Faraday device. Therefore, with regard to the optical isolator of the present invention, each component used and its constitution have properties of low loss and high isolation in a band of 320 to 633 nm, and it functions as a sufficiently small-sized optical isolator.

Explanation of Reference Numerals and Symbols

1    Input polarizer
2    Glass wedge

3     Polarizer holder
4     Faraday device
5     45 degree optical rotator
6     Output polarizer
7     First hollow magnet
8     Second hollow magnet unit
9     Third hollow magnet unit
10    Housing
11    Optic axis
12    Optical axis

**Claims**

1. An optical isolator for a wavelength band of 320 to 633 nm comprising:

   a Faraday device having a Verdet constant at a wavelength of 405 nm of at least 0.70 min/(Oe·cm); and
   a first hollow magnet disposed on the outer periphery of the Faraday device and second and third hollow magnet units disposed so as to sandwich the first hollow magnet on the optical axis,
   the second and third hollow magnet units each comprising 2 or more magnets equally divided in a direction of 90 degrees relative to the optical axis,
   the Faraday device having applied thereto a magnetic flux density B (Oe) in the range of Expression (1) below, and
   the Faraday device being disposed on a sample length L (cm) in the range of Expression (2) below.

$$0.8 \times 10^4 \leq B \leq 1.5 \times 10^4 \qquad (1)$$

$$0.25 \leq L \leq 0.45 \qquad (2)$$

2. The optical isolator according to Claim 1, wherein the Faraday device comprises an oxide represented by Formula (I) below in an amount of at least 95 wt%.

$$Yb_2O_3 \qquad (I)$$

3. The optical isolator according to Claim 2, wherein the oxide is a single crystal.

4. The optical isolator according to Claim 2, wherein the oxide is a ceramic.

5. The optical isolator according to any one of Claims 1 to 4, wherein the Faraday device has an insertion loss of no greater than 1 dB and an extinction ratio of at least 30 dB for a sample length L (cm).

6. The optical isolator according to any one of Claims 1 to 5, wherein the first hollow magnet and the second and third hollow magnet units comprise a neodymium-iron-boron (NdFeB) system magnet.

7. The optical isolator according to any one of Claims 1 to 6, wherein the first hollow magnet has a magnetic field polarity in the direction of the optical axis and the second and third hollow magnet units have mutually opposite magnetic field polarities in directions normal to the optical axis.

8. The optical isolator according to any one of Claims 1 to 7, wherein the second and third hollow magnet units are of a collection of four magnets formed by dividing a cylindrical magnet into four at 90°.

9. The optical isolator according to any one of Claims 1 to 8, wherein it further comprises at least two tabular birefringent crystals and at least one 45 degree optical rotator.

10. The optical isolator according to Claim 9, wherein the tabular birefringent crystal has an optic axis that is at substantially 45 degrees relative to the optical axis and has a thickness of at least 1.0 cm.

11. The optical isolator according to any one of Claims 1 to 10, wherein the first hollow magnet, the second hollow magnet unit, and the third hollow magnet unit are mounted in the interior of a carbon steel housing.

FIG.1

*FIG.2*

# FIG.3

INCIDENT INPUT FARADAY HALF-WAVE OUTPUT
BEAM POLARIZER ROTATOR PLATE POLARIZER

INPUT FARADAY HALF-WAVE OUTPUT BACKWARD
POLARIZER ROTATOR PLATE POLARIZER BEAM

*FIG.4*

EP 2 790 051 A1

## FIG.5

MAGNET OUTER DIAMETER 3.4 cm
(COMPARATIVE EXAMPLE 1,
SAMPLE LENGTH 0.45 cm)

MAGNET OUTER DIAMETER 2.4 cm
(EXAMPLE 1,
SAMPLE LENGTH 0.25 cm)

MAGNET OUTER DIAMETER 1.6 cm
(EXAMPLE 1,
SAMPLE LENGTH 0.40 cm)

MAGNET OUTER DIAMETER 1.4 cm
(EXAMPLE 1,
SAMPLE LENGTH 0.45 cm)

<table>
<tr><td colspan="2" align="center">**INTERNATIONAL SEARCH REPORT**</td><td colspan="2">International application No.<br>PCT/JP2012/081812</td></tr>
</table>

**A.  CLASSIFICATION OF SUBJECT MATTER**
*G02B27/28*(2006.01)i

According to International Patent Classification (IPC) or to both national classification and IPC

**B.  FIELDS SEARCHED**

Minimum documentation searched (classification system followed by classification symbols)
G02B27/28

Documentation searched other than minimum documentation to the extent that such documents are included in the fields searched
|  |  |  |  |
|---|---|---|---|
| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)
JSTPlus/JMEDPlus/JST7580(JDreamII)

**C.  DOCUMENTS CONSIDERED TO BE RELEVANT**

| Category* | Citation of document, with indication, where appropriate, of the relevant passages | Relevant to claim No. |
|---|---|---|
| Y<br>A | Microfilm of the specification and drawings annexed to the request of Japanese Utility Model Application No. 199809/1984(Laid-open No. 114420/1986) (Sumitomo Special Metals Co., Ltd.), 19 July 1986 (19.07.1986), fig. 1, 3 (Family: none) | 1-10<br>11 |
| Y<br>A | JP 2011-150208 A  (Shin-Etsu Chemical Co., Ltd.), 04 August 2011 (04.08.2011), entire text; all drawings & EP 2360511 A1          & CA 2728954 A1 | 1-10<br>11 |

☒  Further documents are listed in the continuation of Box C.          ☐  See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>19 December, 2012 (19.12.12) | Date of mailing of the international search report<br>15 January, 2013 (15.01.13) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2012/081812 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2002-82309 A  (Tokin Corp.),<br>22 March 2002 (22.03.2002),<br>claim 4; paragraphs [0023], [0041]<br>(Family: none) | 6 |
| Y | JP 7-77670 A  (Kyocera Corp.),<br>20 March 1995 (20.03.1995),<br>paragraphs [0004] to [0007]; fig. 6<br>(Family: none) | 9,10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011150208 A